# EUROPEAN PATENT APPLICATION

(11) **EP 1 523 231 A1**
(43) Date of publication of application: **13.04.2005**
(21) Application number: 04024034.3
(22) Date of filing: 08.10.2004
(51) Int. Cl.: H05K 3/42, H05K 3/46

(54) **Method of producing multilayer wired circuit board**

(30) Priority: 09.10.2003 JP 2003350694
(71) Applicant: NITTO DENKO CORPORATION, Ibaraki-shi, Osaka 567-8680 (JP)
(72) Inventor: Hasegawa, Mineyoshi, Ibaraki-shi Osaka 567-8680 (JP); Nakamura, Kei, Ibaraki-shi Osaka 567-8680 (JP); Baba, Toshikazu, Ibaraki-shi Osaka 567-8680 (JP)
(74) Representative: Schwabe - Sandmair - Marx

(57) **Abstract**

A method of producing a multilayer wired circuit board that can suppress making gouge in an adhesive layer when a hole is formed by irradiation with a laser beam, to provide a smoothened inside surface of the hole so as to provide enhanced reliability of electrical connection. A first substrate 4 having the structure wherein a first metal foil 2 and a second metal foil 3 are formed on both sides of a first insulating layer 1 and a second substrate 7 having the structure wherein a third metal foil 6 is formed on a single side of a second insulating layer 5 are prepared, separately. Then, the first metal foil 2 of the first substrate 4 and the second insulating layer 5 of the second substrate 7 are bonded together through an adhesive layer 8. Thereafter, the resultant laminate is irradiated with a laser beam emitting from the first substrate 4 side toward the second substrate 7 side, to form a through hole 9. When the through hole 9 is formed, the adhesive layer 8 is irradiated with the laser beam decayed in energy after applied to the second metal foil 3 and the first metal foil 2. Hence, the adhesive layer can be prevented from being gouged by thermal decomposition, and as such can permit a smoothened inside surface of the through hole 9.

## Description

### BACKGROUND OF THE INVENTION

### Field of the Invention

The present invention relates to a method of producing a multilayer wired circuit board and, more particularly, to a method of producing a multilayer flexible wired circuit board.

### Description of the Prior Art

In general, rigid flexible wired circuit boards are widely used for portable electronic devices and the like in that they can permit reduction in size and weight and density growth of those electronic devices. The rigid flexible wired circuit board usually has a rigid wired circuit portion having the capability of mounting electronic components in which high-density wiring is arranged, and a flexible wired circuit portion having flexibility to flex and formed as a signal transmitting path.

In recent years, the portable electronic devices have been being increasingly advanced to provide a further enhanced multi-mobile, combining the conventional phone-call and data/message-transmission functions with the still picture and moving picture shooting functions. Along with this, the multilayer wired circuit board is also being increasingly demanded to be further reduced in size, weight and thickness, and accordingly the rigid flexible wired circuit board is also being demanded to have a further reduced thickness in the rigid wired circuit portion thereof.

To meet this demand, for example JP Laid-open (Unexamined) Patent Publication No. 2002-299824 proposes a method of producing a multilayer flexible wired circuit board in the following processes: First, a first metal foil and a second metal foil are laminated on both sides of a first insulating layer, respectively, to form a first substrate. Then, the first metal foil and the second metal foil are formed into a predetermined conductive pattern. Sequentially, a second insulating layer of a second substrate and a third insulating layer of a third substrate, both of which are formed separately from the first substrate, are laminated on the first metal foil and the second metal foil through a first adhesive layer and a second adhesive layer, respectively. Thereafter, a third metal foil of the second substrate and a fourth metal foil of the third substrate are removed at a thin-layer portion and also formed into a predetermined conductive pattern at a thick-layer portion.

In the multilayer flexible wired circuit board thus produced, since the number of insulating layers between the first metal foil and the third metal foil at the thick-layer portion can be reduced, the reduction in size, weight and thickness as demanded for the enhancement of the multi-mobile in recent years can be provided.

This multilayer flexible wired circuit board has a via hole and a through hole properly formed by a laser radiation process.

Incidentally, the adhesive used for the flexible wired circuit board including the rigid flexible wired circuit board is required to have good electric characteristic and flexibility. In view of this, synthetic polymer adhesives including acrylic adhesives and epoxy-nitrilebutyl-rubber-base adhesives are widely used as the adhesive for the flexible wired circuit board.

However, when the synthetic polymer adhesive is in the form of an adhesive layer to be laminated, particularly when an aliphatic polymer adhesive is laminated as the adhesive layer, the following problem may occur. That is to say, when a through hole is formed by using a UV-YAG laser, since such an adhesive layer absorbs less radiation in the UV range, the hole is formed dominantly by thermal decomposition, rather than by abrasion. As a result of this, the adhesive layer formed is damaged as if its surface is gouged out, and inside surface of the through hole cannot be smoothened. In this case, there is provided the disadvantage that a through hole plating layer is not laminated properly on the surface of the adhesive layer, causing some defects to reduce reliability of electrical connection.

### SUMMARY OF THE INVENTION

It is an object of the invention to provide a method of producing a multilayer wired circuit board that can suppress making gouge in an adhesive layer when a hole is formed by irradiation with a laser beam, to provide a smoothened inside surface of the hole so as to provide enhanced reliability of electrical connection.

The present invention provides a method of producing a multilayer wired circuit board comprising at least two metal layers and at least one adhesive layer, the method comprising the process of forming a hole extending through the at least two metal layers and the at least one adhesive layer by irradiation with a laser beam, wherein the laser beam is emitted in the above-said process so that the at least one adhesive layer is irradiated with the laser beam as was applied to the at least two metal layers.

According to this method, at least two metal layers are irradiated with the laser beam, first, and as a result, energy of the laser beam is decayed. After the energy of the laser beam is decayed, the at least one adhesive layer is irradiated with the laser beam decayed in energy. Thus, since the at least one adhesive layer is irradiated with the laser beam having an appropriate amount of energy, the adhesive layer is prevented from being gouged. As a result of this, the inside surface of the hole can be smoothened, thus producing enhanced reliability of electrical connection.

The present invention provides a method of producing a multilayer wired circuit board comprising the process of preparing a first substrate comprising a first insulating layer, a first metal foil formed on one surface of the first insulating layer, and a second metal foil formed on the other surface of the first insulating layer; the process of preparing a second substrate comprising a second insulating layer, and a third metal foil formed on one surface of the second insulating layer; the process of bonding the first substrate and the second substrate together through an adhesive layer; and the process of forming a hole extending through at least the first metal foil, the second metal foil, and the adhesive layer by emitting a laser beam from the first substrate side toward the second substrate.

According to this method, the laser beam is emitted from the first substrate side toward the second substrate, so that the first metal foil and second metal foil of the first substrate, or two metal foils, are irradiated with the laser beam, first. As a result of this, the laser beam is decayed in energy. Then, the adhesive layer is irradiated with laser beam after decayed in energy. Thus, since the adhesive layer is irradiated with the laser beam having an appropriate amount of energy, the adhesive layer is prevented from being gouged. As a result of this, the inside surface of the hole can be smoothened, thus producing the multilayer flexible wired circuit board with enhanced reliability of electrical connection.

### BRIEF DESCRIPTION OF THE DRAWINGS

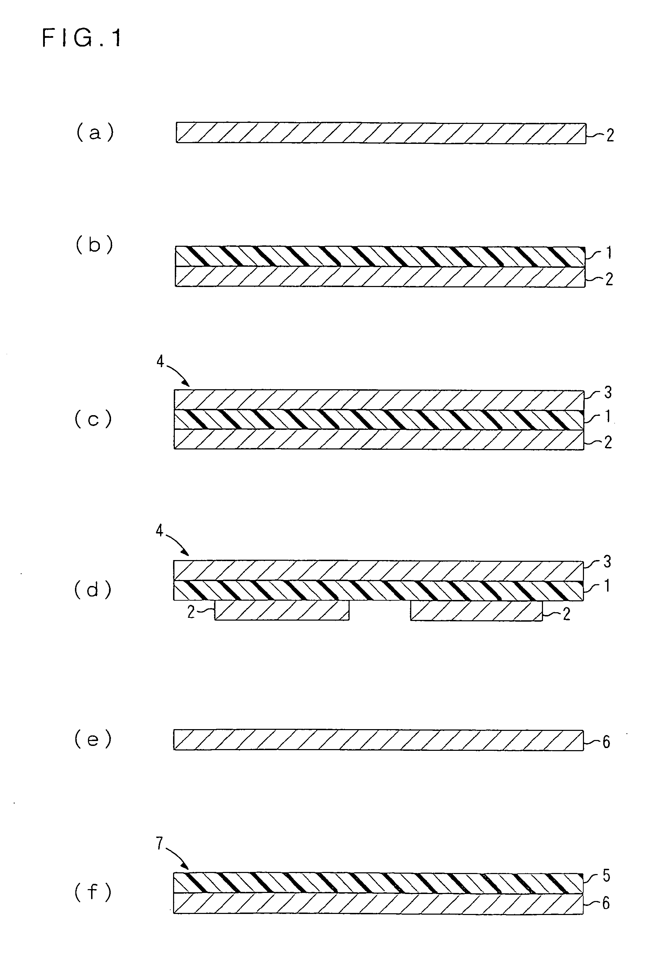

FIG. 1 is a production process drawing of a method of producing a multilayer flexible wired circuit board which is an embodiment of a method of producing a multilayer circuit wiring board of the present invention
   (a) shows the process of preparing a first metal foil;
   (b) shows the process of forming a first insulating layer on a surface of the first metal foil;
   (c) shows the process of laminating a second metal foil on a surface of the first insulating layer, to prepare a first substrate;
   (d) shows the process of forming the first metal foil in a predetermined wired circuit pattern;
   (e) shows the process of preparing a third metal foil; and
   (f) shows the process of forming a second insulating layer on a surface of the third metal foil, to prepare a second substrate separately,

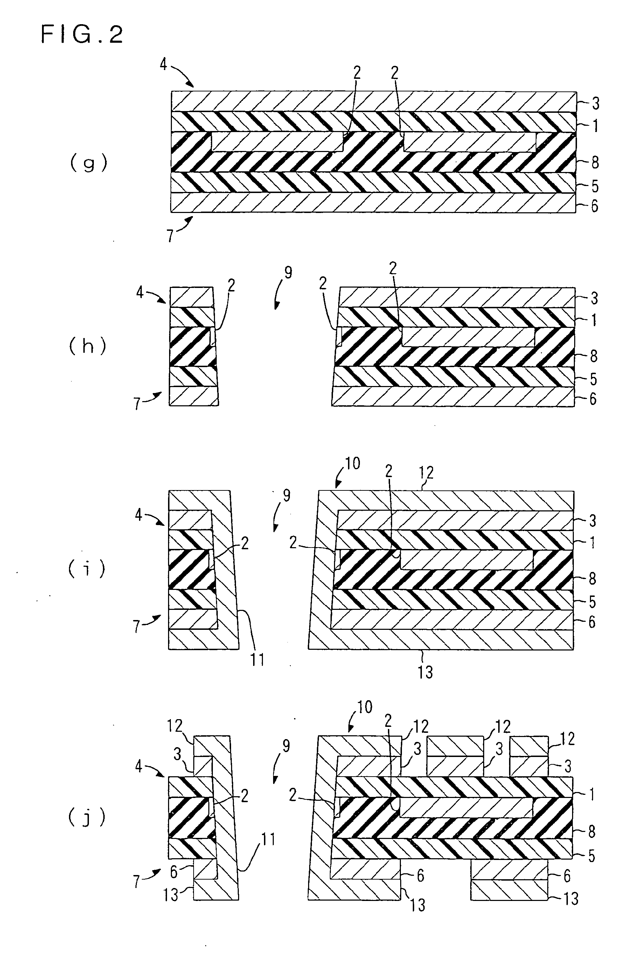

FIG. 2 is a production process drawing subsequent to the production process of FIG. 1, showing the method of producing a multilayer flexible wired circuit board which is an embodiment of a method of producing a multilayer circuit wiring board of the present invention:
   (g) shows the process of bonding the first metal foil of the first substrate and the second insulating layer of the second substrate together via an adhesive layer;
   (h) shows the process of forming a through hole by irradiation with a laser beam from the first substrate side toward the second substrate side;
   (i) shows the process of forming a through-hole plating layer on an inside surface of the through hole, a surface of the second metal foil, and a surface of the third metal foil; and
   (j) shows the process of forming the second metal foil and the second plating layer in a predetermined wired circuit pattern and also forming the third metal foil and the third plating layer in a predetermined wired circuit pattern, and

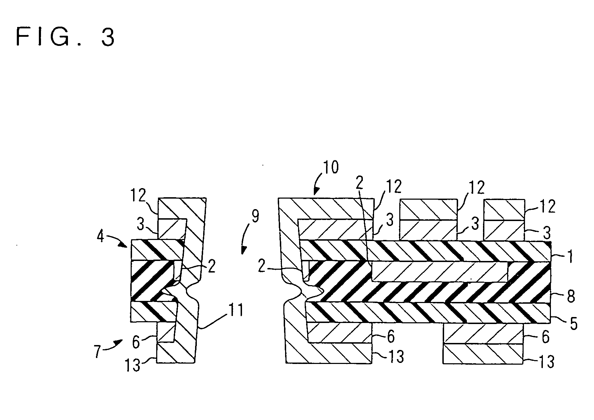

FIG. 3 is a sectional view corresponding to FIG. 2(j) of a multilayer flexible wired circuit board obtained in a comparative example.

### DETAILED DESCRIPTION OF THE PREFERRED EMBODIMENT

FIGS. 1 and 2 are production process drawings showing a method of producing a multilayer flexible wired circuit board which is an embodiment of a method of producing a multilayer circuit wiring board of the present invention.

In the following, a method of producing a multilayer flexible wired circuit board which is an embodiment of a method of producing a multilayer circuit wiring board of the present invention will be described with reference to FIGS. 1 and 2.

In this method, a first substrate 4 comprising a first insulating layer 1, a first metal foil 2 formed on one side of the first insulating layer 1 and serving as a metal layer, and a second metal foil 3 formed on the other side of the first insulating layer 1 and serving as a metal layer is prepared, as shown in FIG. 1(c).

A synthetic resin film is used as the first insulating layer 1. The synthetic resin used for synthetic resin films that may be used include, for example, a polyimide resin, an acrylic resin, a polyether nitrile resin, a polyether sulfonic resin, a polyester terephthalate resin, a polyethylene naphthalate resin, and a polyvinyl chloride resin film. Preferably, the polyimide resin film is used as the first insulating layer 1. The first insulating layer 1 usually has thickness of 12.5µm-50µm, or preferably 12.5µm-25µm.

Also, metal foils are used as the first metal foil 2 and second metal foil 3. Metal used for metal foils that may be used including, for example, a copper, a nickel, a gold, a solder or their alloy. Preferably, the copper foil is used as the first metal foil 2 and second metal foil 3. Each of the first metal foil 2 and the second metal foil 3 usually has thickness of 2µm-35µm, or preferably 9µm-18µm.

No particular limitation is imposed on the process of forming the first metal foil 2 on one side of the first insulating layer 1 and forming the second metal foil 3 on the other side of the same. To take an instance, the first metal foil 2 of a proper metal foil is prepared, first, as shown in FIG. 1(a). Then, after the first metal foil 2 is uniformly coated with synthetic resin solution, to form a coating on the first metal foil 2, the coating is dried and, if necessary, heated to thereby form the first insulating layer 1, as shown in FIG. 1(b). Sequentially, the second metal foil 3 is laminated on a front surface of the first insulating layer 1 (on the front side thereof opposite to the back side on which the first metal foil 2 is laminated) by laminating the metal foil thereon or by plating, as shown in FIG. 1(c).

To be more specific, after the front surface of the first metal foil 2 of the copper foil is uniformly coated with polyamic acid resin solution to form a coating, the coating is dried. Then, after the second metal foil 3 of the copper foil is laminated on the coating, the coating formed of the polyamic acid resin is finally heated to 300°C or more to be cured (imidized), thereby forming the first insulating layer 1 of the polyimide resin and the first substrate 4 at a time.

An alternative process may be taken for forming the first substrate 4. For example, after the front surface of the first metal foil 2 of the copper foil is uniformly coated with polyamic acid resin solution to form a coating, the coating is dried and then is cured (imidized), to form the first insulating layer 1 of the polyimide resin, first. Then, the second metal foil 3 is formed on the front surface of the first insulating layer 1 by copper plating.

Thus, the first substrate 4 is prepared in the form of a double-sided substrate with the first metal foil 2 and the second metal foil 3 formed directly on the both sides of the first insulating layer 1, respectively. A commercially available double-sided substrate may be used as the first substrate 4.

Then, the first metal foil 2 is formed in a predetermined wired circuit pattern, as shown in FIG. 1(d).

The predetermined wired circuit pattern of the first metal foil 2 can be formed by a known patterning process. Preferably, a subtractive process is used to form the first metal foil 2 in a predetermined wired circuit pattern. In the subtractive process, for example an etching resist is formed on the front surface of the first metal foil 2 in a corresponding relation to the predetermined wired circuit pattern. Then, the first metal foil 2 is etched with the etching resist as a resist. Thereafter, the etching resist is removed from the first metal foil 2.

Then, a second substrate 7 comprising a second insulating layer 5 and a third metal foil 6 formed on one side of the second insulating layer 5 and serving as the metal layer is prepared, separately, as shown in FIG. 1(f).

The second insulating layer 5 may be prepared, for example, using the same as the first insulating layer 1. It usually has thickness of 12.5µm-50µm, or preferably 12.5µm-25µm.

Also, the third metal foil 6 may be prepared using the same as the first metal foil 2 and the second metal foil 3. It usually has thickness of 2µm-35µm, or preferably 9µm-18µm.

No particular limitation is imposed on the process of forming the third metal foil 6 on one side of the second insulating layer 5. To take an instance, the third metal foil 6 of a proper metal foil is prepared, first, as shown in FIG. 1(e). Then, after the third metal foil 6 is uniformly coated with synthetic resin solution, to form a coating on the third metal foil 6, the coating is dried and, if necessary, heated to thereby form the second insulating layer 5, as shown in FIG. 1(f).

To be more specific, after a front surface of the third metal foil 6 of the copper foil is uniformly coated with polyamic acid resin solution to form a coating, the coating is dried. Thereafter, the coating is cured (imidized) to form the second insulating layer 5 of polyimide resin.

Thus, the second substrate 7 is prepared in the form of a single-sided substrate with the third metal foil 6 formed directly on a single side of the second insulating layer 5. A commercially available single-sided substrate may be used as the second substrate 7.

Then, the first metal foil 2 of the first substrate 4 and the second insulating layer 5 of the second substrate 7 are bonded to each other through an adhesive layer 8, as shown in FIG. 2(g).

The first metal foil 2 of the first substrate 4 and the second insulating layer 5 of the second substrate 7 can be bonded to each other through the adhesive layer 8 in the following manner. An adhesive is previously applied to either of a surface of the first insulating layer 1 including the first metal foil 2 and a surface of the second insulating layer 5 uniformly, to form the adhesive layer 8. Thereafter, the first metal foil 2 and the second insulating layer 5 are press-bonded to each other through the adhesive layer 8. Alternatively, an adhesive sheet is prepared as the adhesive layer 8, first. Then, with the adhesive sheet interposed between the surface of the first insulating layer 1 including the first metal foil 2 and the surface of the second insulating layer 5, the first insulating layer 1 and the second insulating layer 5 are press-bonded to each other.

The adhesives that may be used include, for example, thermosetting adhesive, such as acrylic adhesive, epoxy adhesive, amideimide adhesive, polyimide adhesive, epoxy-nitrile-butyl-rubber adhesive, epoxy-acrylic-rubber adhesive, butyral adhesive, and urethane adhesive, thermoplastic adhesive such as synthetic rubber adhesive, and pressure-sensitive adhesive such as acrylic pressure-sensitive adhesive.

For example, the adhesive listed above formed in a sheet-like form is used as the adhesive sheet.

It is preferable that light transmission of this adhesive layer is 0.01% or less when the adhesive layer is irradiated with the light having a wavelength of 350nm-360nm. When the light transmission of this adhesive layer is 0.01% or less when irradiated with the light of a wavelength of 350nm-360nm, an inside surface of the through hole 9 corresponding to the adhesive layer 9 can be further smoothened in the formation of the through hole 9, as described later.

The adhesive layer 8 usually has thickness of 5µm-50µm, or preferably 10µm-25µm.

The first substrate 4 and the second substrate 7 are press-bonded to each other through the adhesive layer 8 by pressing them at 100-250°C and at a pressure of 0.1-20MPa in the state in which a surface of the first insulating layer 1 including the first metal foil 2 and the surface of the second insulting layer 5 are overlapped with each other.

If necessary, after the first substrate 4 and the second substrate 7 are combined by press-bonding, the substrates thus combined in one piece may be reduced in thickness by etching the second metal foil 3 and the third metal foil 6.

Thereafter, it is irradiated with a laser beam from the first substrate 4 side toward the second substrate 7 side to pass through the second metal foil 3, the first insulating layer 1, the first metal foil 2, the adhesive layer 8, the second insulating layer 5 and the third metal foil 6 in the thickness direction, to form the through hole 9, as shown in FIG, 2(h).

Although no particular limitation is imposed on the laser beam, the laser beam having a wavelength in the ultraviolet range emitted from the laser such as an excimer laser or a UV-YAG laser, preferably the laser beam from the UV-YAG laser, is used.

The size and shape of the through hole 9 is properly selected for the intended purposes and applications. For example, when formed in a rectangular shape, the through hole 9 is formed to have a maximum length side of 10-300µm, or preferably 25-200µm. When formed in a circular shape, the through hole is formed to have a maximum diameter of 10-300µm, or preferably 25-200µm.

When the hole is bored by irradiation of the laser beam, the energy of the laser beam gradually decays as the laser beam travels farther in order of the second metal foil 3, the first insulating layer 1, the first metal foil 2, the adhesive layer 8, the second insulating layer 5 and the third metal foil 6. As a result of this, the through hole 9 is formed in a tapered shape in section gradually becoming narrowed from the first substrate 4 or the laser beam irradiation side toward the second substrate 7, as schematically illustrated in Fig2 (h).

Sequentially, a through hole plating layer 10 is formed on the inside surface of the through hole 9, the surface of the second metal foil 3 and the surface of the third metal foil 6, as shown in FIG. 2(i).

Although no particular limitation is imposed on the through hole plating layer 10, the through hole plating layer 10 is formed, for example, in the process in which after the inside surface of the through hole 9 is subjected to an electrically conductive treatment by a known method, such as electroless plating, sputtering, or coating with carbon catalyst, the inside surface of the trough hole 9, the surface of the second metal foil 3, and the surface of the third metal foil 6 are plated using the electrolytic plating.

The through hole plating layer 10 is formed by the electrolytic plating of a metal such as copper, nickel, gold, solder, or alloys thereof, or preferably by the electrolytic copper plating.

The through hole plating layer 10 usually has thickness of 5-30µm, or preferably 5-20µm.

This through hole plating layer 10 comprises a first plating layer 11 formed on the inside surface of the through hole 9, a second plating layer 12 formed on the surface of the second metal foil 3, and a third plating layer 13 formed on the surface of the third metal foil 6. The first, second and third plating layers 11, 12, 13 of the through hole plating layer 10 are formed integrally to extend continuously, and as such can allow the second metal foil 3, the first metal foil 2 and the third metal foil 6 to be electrically conductive to each other through the through hole plating layer 10.

The through hole 9 after the formation of the through hole plating layer 10 comes to have the following size. For example, in the case of a rectangle through hole 9, one side thereof on the second metal foil 3 side is 290µm or less, or preferably 200µm or less, while on the other hand, in the case of a circular through hole 9, a diameter thereof on the second metal foil 3 side is 290µm or less, or preferably 200µm or less. Also, one side of the rectangle through hole 9 on the third metal foil 6 side is 285µm or less, or preferably 195µm or less, while on the other hand, a diameter of the circular through hole 9 on the third metal foil 6 side is 285µm or less, or preferably 195µm or less.

Thereafter, the second metal foil 3 and the second plating layer 12 are formed in a predetermined wired circuit pattern and also the third metal foil 6 and the third plating layer 13 are formed in a predetermined wired circuit pattern, as shown in FIG. 2(j).

The predetermined wired circuit pattern of the second metal foil 3 and second plating layer 12 and the predetermined wired circuit pattern of the third metal foil 6 and third plating layer 13 can be formed by a known patterning process. Preferably, the subtractive process is used, as is the case with the above. In the subtractive process, for example etching resists are formed on the surface of the second plating layer 12 and the surface of the third plating layer 13, respectively, in a corresponding relation to their respective predetermined wired circuit patterns. Then, the second metal foil 3 and second plating layer 12, and the third metal foil 6 and third plating layer 13 are etched with those etching resists as the resist. Thereafter, the etching resists are removed therefrom.

After the processes described above, the multilayer flexible wired circuit board comprising three conductor layers is produced wherein the first metal foil 1, the second metal foil 3 and second plating layer 12, and the third metal foil 6 and third plating layer 13 are in the form of the conductor layers having their respective predetermined wired circuit pattern.

In this producing method of the multilayer flexible wired circuit board, the adhesive layer 8 is irradiated with the laser beam applied to the second metal foil 3, the first insulating layer 1, the first metal foil 2 in this order in the process of boring the through hole 9. This means that at least two metal layers of the second metal foil 3 and the first metal foil 2 are irradiated with the laser beam before the adhesive layer 8 is irradiated with the laser beam, which further means that the adhesive layer 8 is irradiated with the laser beam whose energy is decayed. Thus, since the adhesive layer 8 is irradiated with the laser beam having an appropriate amount of energy, the adhesive layer 8 is prevented from being gouged by thermal decomposition at its portion irradiated with the laser beam. As a result of this, the inside surface of the through hole 9 can be smoothened. Hence, even when the through hole plating layer 10 is formed after this process, the formation of defects in the inside surface of the through hole 9 at a portion thereof corresponding to the adhesive layer 8 can be prevented. This can produce enhanced reliability of electrical connection of the multilayer flexible wired circuit board obtained.

While the process that after the first metal foil 2 is formed in a predetermined wired circuit pattern, the first metal foil 2 is bonded to the second insulating layer 5 through the adhesive layer 8 has been described above, this process may be performed in reverse order. That is to say, after the second metal foil 3 is formed in a predetermined wired circuit pattern, the second metal foil 3 thus patterned may be bonded to the second insulating layer 5 through the adhesive layer 8. In this case, the second plating layer 12 is formed on the first metal foil 2 and then the both of them are formed in a predetermined wired circuit pattern simultaneously.

Although the multilayer flexible wired circuit board having three metal foils (metal layers) of the present invention, i.e., three conductor layers, has been illustrated above, as long as the adhesive layer is irradiated with the laser beam decayed after at least two metal foils (metal layers) are irradiated with the laser beam in the process of boring the hole, the number of layers of the metal foils, the number of layers of the insulating layers, and the number of layers of the adhesive layers may be properly selected without being particularly limited to the illustrated ones.

Although the formation of the hole in the form of the through hole 9 extending through the first substrate 4 and the second substrate 7 has been described above, the hole may be in the form of a blind via hole closed at the deepest portion, without being limited to the through hole, as long as it extends through at least two metal foils (metal layers) and at least one adhesive layer.

### EXAMPLES

While in the following, the present invention will be described in further detail with reference to Examples and Comparative Examples, the present invention is not limited to any Examples and Comparative Examples.

### EXAMPLE 1

First, the both-sided copper clad laminate having the structure wherein the first metal foil and the second metal foil which are formed of a copper foil having thickness of 18µm are laminated directly on both sides of the first insulating layer formed of polyimide resin having thickness of 25µm (ESPANEX SB18-25-18CE available from NIPPON STEEL CHEMICAL CO., LTD.) was prepared as the first substrate (Cf. FIG. 1(c)).

Then, the first metal foil was formed in a predetermined wired circuit pattern by the subtractive process (Cf. FIG. 1(d)).

Also, the single-sided copper clad laminate having the structure wherein the third metal foil formed of a copper foil having thickness of 18µm is laminated directly on a single side of the second insulating layer formed of polyimide resin having thickness of 12.5µm (ESPANEX SC18-12-18FR available from NIPPON STEEL CHEMICAL CO., LTD.) was prepared as the second substrate, separately (Cf. FIG. 1(f)).

Then, the first insulating layer including the first metal foil of the first substrate and the second insulating layer of the second substrate were press-bonded to each other through the acrylic adhesive layer having thickness of 25µm (light transmission of 5.9% when irradiated with the light having a wavelength of 355nm) (Cf. FIG. 2(g)).

Thereafter, the second metal foil and the third metal foil were etched uniformly to thickness of 10µm and then were irradiated with the laser beam from the first substrate side toward the second substrate by using the UV-YAG laser having a wavelength of 355nm, to form the through hole extending through the second metal foil, the first insulating layer, the first metal foil, the adhesive layer, the second insulating layer, and the third metal foil (Cf. FIG. 2(h)).

Then, after the inside surface of the through hole was subjected to the electrically conductive treatment by coating with carbon catalyst, the through hole plating layer was formed on the inside surface of the trough hole, the surface of the second metal foil, and the surface of the third metal foil by using the electrolytic copper plating (Cf. FIG. 2(i)).

After the through hole plating layer was formed, the through hole had diameter of 80µm on the second metal foil side and 65µm on the third metal foil side, so that it was tapered in section becoming narrowed gradually from the first substrate side, or the laser beam irradiation side, toward the second substrate.

Thereafter, the second metal foil and the through hole plating layer formed thereon, and the third metal foil and the through hole plating layer formed thereon were formed in predetermined wired circuit patterns by using the subtractive process, to thereby produce the multilayer flexible wired circuit board (Cf. FIG. 2(j)).

### EXAMPLE 2

Except that the first insulating layer including the first metal foil of the first substrate and the second insulating layer of the second substrate were press-bonded to each other through an aromatic amideimide adhesive (light transmission of 0.007% when irradiated with the light having the wavelength of 355nm), the same operation as in Example 1 was conducted to obtain a multilayer flexible wired circuit board.

### COMPARATIVE EXAMPLE 1

Except that the through hole was formed by using the UV-YAG laser having the wavelength of 355nm and emitting the laser beam from the second substrate side toward the first substrate side so that the laser beam can pass through the third metal foil, the second insulating layer, the adhesive layer, the first metal foil, and the second metal foil in the thickness direction in this order, the same operation as in Example 1 was conducted to obtain a multilayer flexible wired circuit board.

### COMPARATIVE EXAMPLE 2

Except that the through hole was formed by using the UV-YAG laser having the wavelength of 355nm and emitting the laser beam from the second substrate side toward the first substrate side so that the laser beam can pass through the third metal foil, the second insulating layer, the adhesive layer, the first metal foil, and the second metal foil in the thickness direction in this order, the same operation as in Example 2 was conducted to obtain a multilayer flexible wired circuit board.

### EVALUATION

### 1) State Observation of Through Hole

The multilayer flexible wired circuit boards obtained in Examples and Comparative Examples were cut in the thickness direction thereof at portions thereof including the through holes to make cross sections of those portions, and those cross sections were observed under a microscope to examine and ascertain the presence of the damage of the adhesive layers in the inside surfaces of the through holes. It was found from this observation that in the multilayer flexible wired circuit boards obtained in Examples, no damage was found in the surface of the bored adhesive layer and that the inside surface of the through hole was smoothened, as schematically illustrated in FIG. 2(j).

It was also found from the observation that in the multilayer flexible wired circuit boards obtained in Comparative Examples, the gouge was found in the bored adhesive layer, as schematically illustrated in FIG. 3, and that the through hole plating layer was not laminated smoothly on the adhesive layer at that concaved portion, so that the defect was provided at that portion.

### 2) Reliability of Electrical Connection

The multilayer flexible wired circuit boards obtained in Examples and Comparative Examples were served to the temperature cycling test to evaluate the reliability of electrical connection.

The temperature cycling conditions: Repetition of the hot condition of 125°C for thirty minutes and the cold condition of -40°C for thirty minutes was defined as one cycle. The reliability of electrical connection was evaluated by the number of cycles counted until a rate of change of resistant becomes 10% or more.

It was found from this test that in both of Examples, the original values of resistance were kept even when 1,000 cycles or more was counted. It was also found from this test that in Comparative Example 1, the rate of change of resistance became 10% or more at 50 cycles and in Comparative Example 2, the rate of change of resistance became 10% or more at 750 cycles.

While the illustrative embodiments of the present invention are provided in the above description, such is for illustrative purpose only and it is not to be construed restrictively. Modification and variation of the present invention that will be obvious to those skilled in the art is to be covered by the following claims.

## Claims

1. A method of producing a multilayer wired circuit board comprising at least two metal layers and at least one adhesive layer, the method comprising:
the process of forming a hole extending through the at least two metal layers and the at least one adhesive layer by irradiation with a laser beam,
wherein the laser beam is emitted in the above-said process so that the at least one adhesive layer is irradiated with the laser beam as was applied to the at least two metal layers.

2. A method of producing a multilayer wired circuit board, which comprises:
the process of preparing a first substrate comprising a first insulating layer, a first metal foil formed on one surface of the first insulating layer, and a second metal foil formed on the other surface of the first insulating layer;
the process of preparing a second substrate comprising a second insulating layer, and a third metal foil formed on one surface of the second insulating layer;
the process of bonding the first substrate and the second substrate together through an adhesive layer; and
the process of forming a hole extending through at least the first metal foil, the second metal foil, and the adhesive layer by emitting a laser beam from the first substrate side toward the second substrate.
